Europäisches Patentamt

European Patent Office

Office européen des brevets

(19)

(11) **EP 1 018 804 A1**

(12) **EUROPEAN PATENT APPLICATION**

(43) Date of publication:
**12.07.2000 Bulletin 2000/28**

(51) Int Cl.[7]: **H03K 3/011**

(21) Application number: **99400009.9**

(22) Date of filing: **05.01.1999**

(84) Designated Contracting States:
**AT BE CH CY DE DK ES FI FR GB GR IE IT LI LU MC NL PT SE**
Designated Extension States:
**AL LT LV MK RO SI**

(71) Applicant: **MOTOROLA, INC.**
**Schaumburg, IL 60196 (US)**

(72) Inventors:
• **Laudenbach, Andreas**
  **82527 Haag (DE)**

• **Ollitrault, Stephane**
  **31600 Seysess (FR)**
• **Bode, Hubert**
  **85540 Haar (DE)**

(74) Representative: **Gibson, Sarah Jane et al**
**Motorola**
**European Intellectual Property Operations**
**Midpoint**
**Alencon Link**
**Basingstoke, Hampshire RG21 7PL (GB)**

(54) **An oscillator**

(57)    An oscillator 1 for generating an overall output oscillating signal 8 whose frequency f8 is substantially stable over a predetermined temperature range and voltage supply range, the oscillator 1 comprising a voltage regulation portion 5 for generating a partially regulated voltage signal 6 from an unstable voltage supply, the partially regulated voltage signal 6 varying in dependence on the ambient temperature of the oscillator 1 in accordance with a first temperature dependency; and a temperature and voltage dependent oscillator portion 7 which is supplied by the partially regulated voltage signal 6, the oscillator portion 7 being adapted for generating an oscillating signal 8 whose frequency f8 varies both in dependence on the ambient temperature of the oscillator 1 in accordance with a second temperature dependency and in dependence on the voltage of the partially regulated voltage signal 6 in accordance with a first voltage dependency, the oscillator portion 7 being arranged such that the effect of the second temperature dependency substantially cancels the combined effect of the first temperature dependency together with the first voltage dependency such that the overall temperature dependency of the oscillator 1, within the predetermined temperature range and voltage supply range, is within a predetermined tolerance.

FIG. 1

**Description**

Background of the Invention

This invention relates, in general, to an oscillator and, more particularly, to a square wave oscillator circuit.

A square wave oscillator is used for generating the clocking signal in synchronous digital systems such as computers, communications equipment, and electronic devices for automotive applications. In such applications, maintaining a stable clock frequency, thus oscillator frequency, is necessary for the proper operation of the equipment. The stable oscillator frequency must be maintained despite having wide temperature variations in the operating environment of the equipment such as under the hood of an automobile.

In the past, adjustments to obtain proper oscillator frequency were accomplished by various methods of trimming the resistance value of the oscillator circuit. However, trimming the resistance value at the time of manufacture of the oscillator does not provide frequency stability when the oscillator is operating in an environment of wide ranging temperature.

US patent No. 5,386,201 describes a square wave oscillator which does not require trimming and which generates an output square wave signal at a frequency which is relatively stable at a fixed frequency over a fairly large temperature range. However, to achieve this frequency stability over temperature, a stable voltage supply is required. In some applications such as the production of mechatronic devices for automobile applications, it would be desirable to have a square wave oscillator which is stable over a large temperature range and which does not require a stable voltage supply but can be supplied instead by an unstable voltage supply, such as, for example, directly by a car battery.

Hence, there exists a need for an oscillator which can maintain frequency stability while operating at a wide temperature range even when supplied by an unstable voltage supply.

Summary of the Invention

According to the present invention, there is provided an oscillator for generating an overall output oscillating signal whose frequency is substantially stable over a predetermined temperature range and voltage supply range, the oscillator comprising a voltage regulation portion for generating a partially regulated voltage signal from an unstable voltage supply, the partially regulated voltage signal varying in dependence on the ambient temperature of the oscillator in accordance with a first temperature dependency; and a temperature and voltage dependent oscillator portion which is supplied by the partially regulated voltage signal, the oscillator portion being adapted for generating an oscillating signal whose frequency varies both in dependence on the ambient temperature of the oscillator in accordance with a second temperature dependency and in dependence on the voltage of the partially regulated voltage signal in accordance with a first voltage dependency, the oscillator portion being arranged such that the second temperature dependency substantially cancels the combined effect of the first temperature dependency together with the first voltage dependency such that the overall temperature dependency of the oscillator, within the predetermined temperature range and voltage supply range, is within a predetermined tolerance.

Thus the temperature dependency of the oscillator as a whole is less than a required amount even though the combined effect of the first temperature dependency together with the first voltage dependency would be unacceptably large if it were not for the cancellation effect of the second temperature dependency.

The advantage of the present invention is that it is possible to generate an oscillating signal whose frequency is substantially stable (i.e. deviates from the mean frequency of oscillation by less than ±5% or preferably by less than ±2%) within a predetermined temperature range (preferably of -40°C to +125°C) without requiring a temperature stable voltage regulator or voltage regulation portion. This enables a much cheaper voltage regulation portion to be used thus significantly lowering the cost of the oscillator as a whole.

Preferably, the first temperature dependency (i.e. of the voltage regulation portion) corresponds to the temperature dependence of the breakdown voltage of a relatively low voltage (i.e. about 5.3V) zener diode. Preferably, the second temperature dependency (i.e. of the oscillator portion) depends upon the temperature dependency of the forward biased voltage drop across a pn junction.

Preferably, the voltage regulation portion comprises a voltage buffer means whose input signal is derived from a relatively low voltage zener diode.

Preferably, the oscillator portion includes a resistor-capacitor combination having a time constant associated therewith which time constant varies in dependence on the ambient temperature, the resistor-capacitor combination further including one or more pn junctions, connected in series with the resistor of the resistor-capacitor combination, in order to compensate for the temperature dependency of the resistor, wherein the temperature dependency of the resistor is under-compensated by a predetermined amount in order to generate the second temperature dependency (i.e. the temperature dependency of the oscillator portion).

Preferably, the oscillator is formed as part of a single mechatronic package.

Brief Description of the Drawings

Figure 1 is a block diagram an oscillator in accordance with the present invention;

Figure 2 is a block diagram of a voltage regulation portion suitable for use in the oscillator of Figure 1; and

Figure 3 is a block diagram of an oscillator portion suitable for use in the oscillator of Figure 1.

Detailed Description of the Drawings

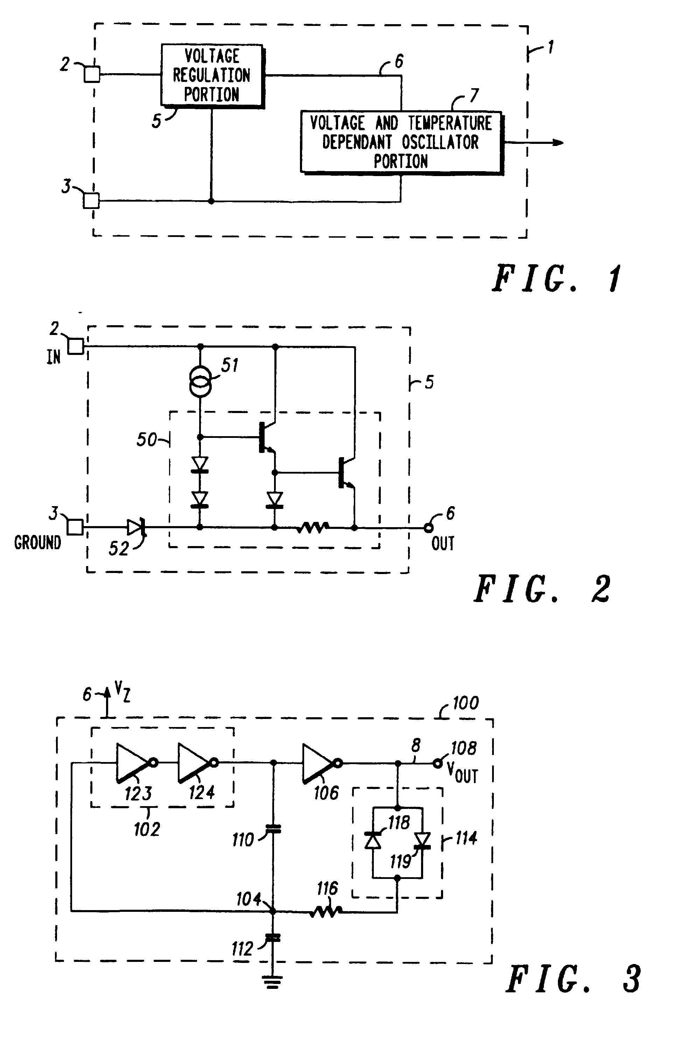

Figure 1 shows a mechatronic package 1 having a supply voltage terminal 2 and a ground terminal 3 which together constitute the supply terminals 2,3, a voltage regulation portion 5 which outputs a partially regulated voltage signal 6 and a voltage and temperature dependent oscillator portion 7 which outputs a substantially stable oscillating signal 8. The voltage regulation portion 5 together with the voltage and temperature dependent oscillator portion 7 together form an oscillator 5,7 for generating an overall output oscillating signal whose frequency is substantially stable over a predetermined temperature range and voltage supply range. An unstable voltage supply (e.g. from a car battery the voltage from which can commonly vary between 9V and 16V) is connected across terminals 2 and 3 and provides power to the voltage regulation portion 5. Voltage regulation portion 5 generates a partially regulated voltage signal 6 which is independent of the supply voltage connected across the supply terminals 2,3 but which varies with temperature. In one preferred embodiment of the present invention, the partially regulated voltage signal varies substantially according to the temperature dependence of the breakdown voltage, Vz, of a relatively low voltage (e.g. 5.3V) zener diode. The temperature dependence of a zener diode over the temperature range relevant to automobile applications of -45°C to +125°C can be approximately expressed as:-

$$Vz = Vz_{27C} + C_1 T + C_2 (T)^2$$

Where $Vz_{27C}$ is the breakdown voltage of the zener diode at 27°C, $C_1$ is a first constant, $C_2$ is a second constant and T is temperature deviation of the zener diode from 27°C. In a preferred embodiment in which the voltage regulation portion 5 is formed as an integrated circuit on a silicon substrate, $Vz_{27C} = 5.3V$, $C_1 \approx 1.4$ mV/°C, and $C_2 \approx 0$ mV/°C². This temperature dependency of Vz may be termed the first temperature dependency or the temperature dependency of the voltage regulation portion 5.

The partially regulated voltage signal 6 is supplied to the voltage and temperature dependent oscillator portion 7 which generates an output oscillating signal 8, the frequency of which depends both on the value of the partially regulated voltage signal 6 which is supplying power to the oscillator portion and the ambient temperature of the oscillating portion. In a preferred embodiment, the oscillator portion includes a resistor-capacitor combination having a time-constant associated therewith. In such a combination, the time-constant essentially determines how long it takes for the capacitor part of the resistor-capacitor combination to charge up to or discharge down to a particular trigger voltage via the resistor part of the resistor-capacitor combination for a given voltage across the resistor-capacitor combination. The time taken, $\tau$, for this to occur is essentially what determines the frequency, $f_8$, of the output oscillating signal 8 (note $f_8 = 1/(\tau + \tau)$ where $\tau$ represents other small delays associated with the oscillator circuit 7). It will be appreciated by a person skilled in the art, that an increased voltage across the resistor part of the resistor-capacitor combination will reduce the amount of time taken to charge or discharge the capacitor by a given amount. The change in time will not be exactly linear in relation to the change in voltage but for small changes in the voltage (corresponding to the small changes in the partially regulated voltage signal occurring as a result of temperature variations between -45°C and +125°C) it can be approximated as such. Since the voltage across the resistor-capacitor combination will depend upon the value of the partially regulated voltage signal 6, we can say that the frequency, $f_8$, of signal 8 varies approximately according to:-

$$f_8(Vz) = f_8(Vz_{27C}) \cdot (1 + (Vz - Vz_{27C})/Vz_{27C})$$

This may be termed the first voltage dependency or the voltage dependency of the oscillator portion 7.

Furthermore, a change in ambient temperature of the oscillator portion 7, will cause the resistance of the resistor part of the resistor-capacitor combination to change, which will also vary the frequency $f_8$ of signal 8. In particular, an increase in temperature will cause a corresponding increase in the resistance of the resistor part of the resistor-capacitor combination which will cause a corresponding increase in the characteristic time of the resistor-capacitor combination which will cause a corresponding decrease in the frequency, $f_8$, of signal 8. This frequency variation due to temperature can be compensated for by including one or more forwardly biased pn junctions in series with the resistor part of the resistor-capacitor; the compensation occurs because an increase in temperature causes the voltage drop across the forwardly biased pn junctions to fall which results in a greater voltage across the resistor; the greater voltage across the resistor compensates for the increased resistance of the resistor. This compensation mechanism is discussed in greater detail in US patent No. 5,386,201 which is incorporated herein by way of reference. However, oscillator portion 7 is deliberately under-compensated (by removing one or more forwardly biased pn junctions compared to the fully compensated case) such that for a hypothetically fixed, partially regulated voltage signal 6 an increase in ambient temperature would result in a lower frequency, $f_8$, of the oscillating signal 8. This deliberately enabled temperature dependency of the oscillator portion may be termed the second temperature dependency or the temperature dependency of the oscillator portion 7.

However, in oscillator 5,7 the second temperature dependency is substantially canceled by the combined effect of the first temperature dependency and the first voltage dependency. In this way, the frequency, $f_8$, of the output signal 8 is maintained substantially constant despite temperature fluctuations between minus 45°C and 125°C. For this to work correctly it is necessary for the regulator portion 5 to be in some way thermally linked to, and/or preferably in thermal equilibrium with, oscillator portion 7 and this is achieved in oscillator 1 of Figure 1 by placing these two elements within the same mechatronic package.

Turning now to Figure 2 (in which similar elements have been given the same reference numerals as in Figure 1), voltage regulation portion 5 (suitable for use in the oscillator 5,7 of Figure 1) is shown as comprising a Darlington Pair voltage buffer arrangement 50, constant current source 51 and zener diode 52. The arrangement is such that constant current source 51 causes current to flow through zener diode 52 which thus generates a voltage signal thereacross which is fed to the Darlington Pair voltage buffer 50. The operation of the Darlington Pair buffer arrangement is well understood in the art and will not be described in great detail here except to point out that it provides a relatively stable partially regulated output signal 6 which does not depend on the Voltage supplied across the supply terminals 2,3 but does depend on the temperature (as this affects the reference voltage U(T) generated by the zener diode 52). Furthermore, it is worth noting that the regulation portion 5 is very cheap and easy to produce in the form of an integrated circuit because it does not include any temperature compensation circuits such as a band gap reference together with a feedback loop or a temperature compensated zener diode.

Figure 3 illustrates a detailed schematic/block diagram of oscillator circuit 100 which could be used as the voltage and temperature dependent oscillator portion 7 in Figure 1. Oscillator circuit 100 includes buffer circuit 102 having an input coupled to circuit node 104 and an output coupled to circuit node 103 which is coupled to an input of inverter circuit 106. An output of inverter 106 is coupled to terminal 108 for providing an oscillatory signal thereat.

Oscillator circuit 100 includes capacitor 110 coupled between the output of buffer circuit 102 and circuit node 104. Capacitor 112 is coupled between circuit node 104 and first supply voltage terminal at which ground reference is applied. It is worth noting that oscillator circuit 100 is coupled to a second supply voltage terminal at which the partially regulated voltage signal 6 is applied; the partially regulated voltage signal 6 is used to power the inverters 106,123,124 and thus determines the output voltage of these when they are outputting a high signal. Oscillator circuit 100 also includes resistor 116 having a first terminal and a second terminal connected to circuit node 104. Resistor 116 together with capacitors 110,112 form a resistor-capacitor combination 110,112,116, resistor 116 forming the resistor part thereof. The resistor-capacitor combination has a time constant associated therewith such that for a given voltage applied at the first terminal of resistor 116, and for a given voltage applied at the output of buffer 102, (assuming a constant temperature and thus resistance of resistor 116) the capacitors 110, 112 will take a known length of time to charge or discharge from one state to another, the time taken being dependent on the time constant associated with the resistor capacitor combination 110,112,116.

Oscillator circuit 100 also includes diode circuit 114 for providing partial temperature compensation of the resistor-capacitor combination. In particular, diode circuit 114 is coupled between the output of inverter 106 and the first terminal of resistor 116. The second terminal of resistor 116 is coupled to circuit node 104.

Diode circuit 114 includes diodes 118,119. Diode 118 has a cathode coupled to the output of inverter 106 and an anode coupled to the first terminal of resistor 116. Similarly, diode 119 has an anode coupled to the output of inverter 106 and a cathode coupled to the first terminal of resistor 116.

Buffer circuit 102 includes serially coupled inverters 123 and 124. The input of inverter 123 is coupled to circuit node 104 while its output is coupled to an input of inverter 124. Also, the output of inverter 124 is coupled to the output of buffer circuit 102.

In operation, buffer 102 detects and amplifies the signal at node 104 and drives node 130. If the voltage at node 104 is below the voltage threshold of 102, then the output at node 130 will be driven nearly equal to the ground potential.

Inverter 106 provides for inverting the signal at node 130 and driving the output node 108. If the input voltage at node 130 is equal to ground, the output node 108 is driven to the supply potential thus charging the capacitors 110 and 112 through the resistor 116 and diode circuit 114 (diode 119).

The voltage at node 104 rises in a controlled manner determined by the time constant of the resistor 116, capacitors 110 and 112, voltage drop across diode circuit 114, and the voltage source at node 108 (output of inverter 106).

Once the voltage at node 104 rises above the voltage threshold of buffer 102, the voltage at node 130 changes from ground potential to the supply potential. The rise of the voltage at node 130 causes the voltage at node 104 to rise from the threshold potential to a higher potential. The voltage rise at node 104 is set by the ratio of capacitors 112 and 110. For example, if the value of capacitor 112 is at least 67% of the value of capacitor 110 and the threshold of the buffer 102 is equal to approximately half the supply voltage, then the voltage at node 104 will not rise more than the supply voltage.

Once the voltage at node 130 has risen above the threshold of inverter 106, the voltage at the output node 108 switches to equal the ground potential thereby providing a square wave output. When the voltage at node 108 equals the ground potential, the capacitors 110 and 112 are discharged through resistor 116 and diode circuit 114 (diode 118).

The voltage at node 104 falls in a controlled manner determined by the time constant of the resistor 116, capacitors 110 and 112, voltage drop across diode circuit 114, and the voltage source at node 108 (output of inverter 106).

Once the voltage at node 104 drops below the voltage threshold of buffer 102, the voltage at node 130 changes from supply potential to ground. The drop of the voltage at node 130 causes the voltage at node 104 to drop from the threshold potential to a lower potential. The voltage drop at node 104 is set by the ratio of capacitors 112 and 110 as previously described. Note that the voltage drop at node 104 can be prevented from dropping below the ground potential. Thus, the present invention constrains the voltage at node 104 to stay within the supply rails thereby preventing parasitic charge injection into the resistor junction isolation regardless of the type of resistor used in the integrated circuit.

Buffer 102 and an inverter 106 provide high input impedance (i.e. low capacitive loading) and low output impedance (good drive capability). The gain of the buffer must be sufficient to ensure oscillation. The buffer 102 may be formed by combining an even number of inverters connected in series, see inverters 123 and 124 forming buffer 102 in FIG. 1. Inverter 106 in FIG. 1 may be formed by combining an odd number of inverters connected in series. The inverters should be sized appropriately, for example, with small inverters forming the input stage and larger inverters forming the output stage as commonly used for buffering and inverting stages.

The value of resistor 116 increases as temperature increases. The value can be approximated by the following equation:

$$R116(@T) =$$

$$R116(@27C) * (1 + (530E\text{-}6)*T + (3.5E\text{-}6)*T^2)$$

Note that the variation of the resistance is slightly parabolic. The voltage drop across the diode circuit 114 varies inversely with temperature and is equal to -1 mV per degree centigrade. The increasing value of resistance is partially compensated for by the decreasing value of the voltage drop across the diodes and further compensated by the increasing value of the partially regulated voltage signal 6 thereby providing substantially equal net charging and discharging currents. It should be appreciated that all diffusion resistors exhibit a positive temperature variance and may be partially compensated for by a diode circuit, if necessary, including one or more series connected diodes.

It should also be noted that diode circuit 114 comprising diodes 118, 119 may be further connected in pairs without substantially changing the operation. It is worth noting that other diode configurations may be used as required to achieve the best frequency compensation for a given process. A fully integrated temperature stable oscillator requiring no external components has been presented. It should be appreciated by now that we have shown a simple fully integrated circuit for stabilizing the frequency variation of a square wave oscillator without the need for a temperature compensated voltage regulator.

## Claims

1. An oscillator for generating an overall output oscillating signal whose frequency is substantially stable over a predetermined temperature range and voltage supply range, the oscillator comprising a voltage regulation portion for generating a partially regulated voltage signal from an unstable voltage supply, the partially regulated voltage signal varying in dependence on the ambient temperature of the oscillator in accordance with a first temperature dependency; and a temperature and voltage dependent oscillator portion which is supplied by the partially regulated voltage signal, the oscillator portion being adapted for generating an oscillating signal whose frequency varies both in dependence on the ambient temperature of the oscillator in accordance with a second temperature dependency and in dependence on the voltage of the partially regulated voltage signal in accordance with a first voltage dependency, the oscillator portion being arranged such that the effect of the second temperature dependency substantially cancels the combined effect of the first temperature dependency together with the first voltage dependency such that the overall temperature dependency of the oscillator, within the predetermined temperature range and voltage supply range, is within a predetermined tolerance.

2. An oscillator as claimed in claim 1 wherein the first temperature dependency corresponds to the temperature dependency of the breakdown voltage of a zener diode.

3. An oscillator as claimed in claim 2 wherein the voltage regulation portion includes a zener diode, the breakdown voltage of which is used to generate the partially regulated voltage signal.

4. An oscillator as claimed in any one of the preceding claims wherein the oscillator portion includes a resistor-capacitor combination having a time constant associated therewith which time constant varies in dependence on the ambient temperature, the resistor-capacitor combination further including one or more pn junctions, connected in series with the resistor of the resistor-capacitor combination, in order to compensate for the temperature dependency of the resistor, wherein the temperature dependency of the resistor is under-compensated by a predetermined amount in order to generate the second temperature dependency.

5. An oscillator as claimed in any one of the preceding claims wherein the oscillator is formed as part of a single mechatronic package.

*FIG. 1*

*FIG. 2*

*FIG. 3*

**European Patent Office**

# EUROPEAN SEARCH REPORT

Application Number

EP 99 40 0009

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | G. GRAICHEN: "Hochstabiler Impulsgeber" RADIO FERNSEHEN ELEKTRONIK., vol. 26, no. 19, October 1977, pages 675-676, XP002104933 BERLIN DD * page 675, right-hand column, line 20 - line 37; figure 1 * | 1,5 | H03K3/011 |
| Y | | 2,3 | |
| Y | EP 0 040 260 A (LICENTIA GMBH) 25 November 1981 * page 2, line 30 - page 3, line 17 * | 2,3 | |
| A,D | US 5 386 201 A (BENNETT PAUL T ET AL) 31 January 1995 * column 1, line 62 - column 3, line 57 * | 4 | |

TECHNICAL FIELDS
SEARCHED     (Int.Cl.6)

H03K
H03L

The present search report has been drawn up for all claims

| Place of search | Date of completion of the search | Examiner |
|---|---|---|
| THE HAGUE | 4 June 1999 | Cantarelli, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 99 40 0009

This annex lists the patent family members relating to the patent documents cited in the above-mentioned European search report.
The members are as contained in the European Patent Office EDP file on
The European Patent Office is in no way liable for these particulars which are merely given for the purpose of information.

04-06-1999

| Patent document cited in search report | | Publication date | Patent family member(s) | | Publication date |
|---|---|---|---|---|---|
| EP 0040260 | A | 25-11-1981 | DE | 3019162 A | 26-11-1981 |
| | | | US | 4413192 A | 01-11-1983 |
| US 5386201 | A | 31-01-1995 | EP | 0655833 A | 31-05-1995 |
| | | | JP | 7202644 A | 04-08-1995 |

EPO FORM P0459

For more details about this annex : see Official Journal of the European Patent Office, No. 12/82